# EUROPEAN PATENT APPLICATION

(11) **EP 2 410 579 A1**
(43) Date of publication of application: **25.01.2012**
(21) Application number: 11174346.4
(22) Date of filing: 18.07.2011
(51) Int. Cl.: H01L 31/18, H01L 21/768, H01L 21/67, H01L 51/00

(54) **Method and system for application of an insulating dielectric material to photovoltaic module substrates**

(30) Priority: 23.07.2010 US 842106
(71) Applicant: PrimeStar Solar, Inc, Arvada, CO 80004 (US)
(72) Inventor: Feldman-Peabody, Scott Daniel, Arvada, CO Colorado 80004 (US); Gossman, Robert Dwayne, Arvada, CO Colorado 80004 (US); Lucas, Tammy Jane, Arvada, CO Colorado 80004 (US)
(74) Representative: Szary, Anne Catherine

(57) **Abstract**

A method and related system are provided for depositing a dielectric material (38) into voids (26) in one or more of the semiconductor material layers (27) of a photovoltaic (PV) module (10) substrate (12). A first side of the substrate is exposed to a light source (32) such that light is transmitted through the substrate (12) and any voids (26) in the semiconductor material layers (27) on the opposite side of the substrate. The light transmitted through the voids (26) is detected and a printer (34) is registered to the pattern of detected light to print a dielectric material (38) and fill the voids (26).

## Description

### FIELD OF THE INVENTION

The subject matter disclosed herein relates generally to photovoltaic (PV) modules, and more particularly to a method and system for applying a dielectric material to a substrate during the manufacture of the PV modules.

### BACKGROUND OF THE INVENTION

Thin film photovoltaic (PV) modules (also referred to as "solar panels" or "solar modules") are gaining wide acceptance and interest in the industry, particularly modules based on cadmium telluride (CdTe) paired with cadmium sulfide (CdS) as the photoreactive components. These modules typically include multiple film layers deposited on a glass substrate before deposition of the CdTe layer. For example, a transparent conductive oxide (TCO) layer is first deposited onto the surface of the glass substrate. A resistive transparent buffer (RTB) layer is then applied on the TCO layer. The RTB layer may be a zinc-tin oxide (ZTO) layer and may be referred to as a ZTO layer. A cadmium sulfide (CdS) layer is applied on the ZTO layer. These layers are typically applied in a sputtering deposition process that involves ejecting material from a target (i.e., the material source), and depositing the ejected material onto the substrate to form the film. The CdTe layer is then deposited over the CdS layer, typically by a vapor deposition process.

The substrate then undergoes various processing steps, including laser scribing processes, to define and isolate individual cells, define a perimeter edge zone around the cells, and to connect the cells in series. These steps result in generation of a plurality of individual solar cells defined within the physical edges of the substrate. The laser scribing process entails defining a first isolation scribe through the photoreactive layers and underlying layers down to the glass substrate. The scribe line is then filled with dielectric material before application of the back contact layer.

A common technique for filling the isolation scribe is a photoresist development process wherein a liquid negative photoresist (NPR) material is coated onto the CdTe layer by spraying, roll coating, screen printing, or any other suitable application process. The substrate is then exposed to light from below such that the NPR material in the scribes (and any pinholes in the CdTe material) are exposed to the light, causing the exposed NPR polymers to crosslink and "harden." The substrate is then "developed" in a process wherein a chemical developer is applied to the CdTe surface to dissolve any unhardened NPR. In other words, the NPR that was not exposed to the light is washed away from the CdTe layer by the developer.

The photoresist application process described above requires numerous steps, and is inherently inefficient and wasteful in that the majority of the NPR material is dissolved and washed away in the development step, which adds unnecessary cost to the manufacturing process.

U.S. Pat. No. 5,536,333 describes a process wherein pinholes in the semiconductor layers are detected by passing the substrates over a backlit zone and transferring the information to a computer controlled multiple head delivery system to fill the pinholes with a viscous nonconductive material. The patent, however, provides no guidance on filling relatively large isolation scribe lines.

Accordingly, there exists an ongoing need in the industry for an improved system for applying a dielectric material to scribe lines that reduces the number of processing steps and makes efficient use of the dielectric material.

### BRIEF DESCRIPTION OF THE INVENTION

Aspects and advantages of the invention will be set forth in part in the following description, or may be obvious from the description, or may be learned through practice of the invention.

Embodiments in accordance with aspects of the invention include a method for depositing a dielectric material into voids in one or more of the semiconductor material layers of a photovoltaic (PV) module substrate. The voids may be laser scribe lines that are defined in the layers, or holes or defects in the layers. The method includes exposing a first side of the substrate to a light source such that light is transmitted through the substrate and any voids in the semiconductor material layers on the opposite side of the substrate. The light transmitted through the voids is detected and used to control a printer, for example an inkjet printer, which prints a dielectric material onto the substrate in the areas of the detected light to fill the voids.

The substrates and printer may be coordinated in various manners. For example, the substrates may be conveyed in a linear direction past the printer, with the printer controlled to move in a back-and-forth direction relative to the linear direction to fill the voids across the width of the substrate. In an alternate embodiment, the printer may be controlled to move across the length and width of the substrate, which may be held stationary, to fill the voids.

In a particular embodiment, the light transmitted through the voids is detected by a light detector that is integral with the printer. In an alternate embodiment, a separate detector and associated control circuitry may generate a print image or file from the pattern of detected light and transmit this image or file to the printer, whereby the printer prints the image on the substrate to fill the voids.

A further embodiment may include the steps of conducting a subsequent light transmission test through the substrate to determine if the voids were satisfactorily filled. The results of this test may also be used as a corrective feedback signal for the printer to account for any alignment or registration errors between the printer and the detected light pattern.

Variations and modifications to the processes discussed above are within the scope of the invention and may be further described herein.

The invention also encompasses various system embodiments in accordance with the aspects discussed above. For example, an exemplary system may include a light source disposed so as to transmit light to a first side of the substrates such that the light is transmitted through the substrate and voids in the semiconductor material layers on the opposite side of the substrate. The substrates may be conveyed past the light source, or the light source may be brought to the substrates. A light detector is disposed on the opposite side of the substrates to detect light transmitted through the voids. A printer is configured in communication with the light detector to print a dielectric material onto areas of the substrate corresponding to the detected light to fill the voids with a printable dielectric material.

A particular system embodiment may include a conveyor that moves the substrates in a linear direction past the printer, with the printer movable in a back-and-forth direction relative to the linear direction to fill the voids across the width of the substrate. In an alternative system embodiment, the printer may be controlled to traverse the length and width of the substrates, which may be held stationary, to fill the void.

The light detector may be formed as integral component with the printer or may be in communication with the printer through a control circuit. For example, the transmitted light may be detected and a print image or file generated at a first location of the substrates. The printer may receive the image or file at a downstream print location to print the image on the substrate, thus filling the voids that generated the image.

Yet another system may include a downstream light transmission tester configured to conduct a subsequent light transmission test through the substrate to determine if the voids were satisfactorily filled by said system. The results from this test may also be used to provide a corrective feedback signal to said printer.

Variations and modifications to the system embodiments discussed above are within the scope of the invention and may be further described herein.

These and other features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention.

### BRIEF DESCRIPTION OF THE DRAWINGS

A full and enabling disclosure of the present invention, including the best mode thereof, directed to one of ordinary skill in the art, is set forth in the specification, which makes reference to the appended figures, in which:
Fig. 1 is a cross-sectional view of a photovoltaic module;
Fig. 2 is a cross-sectional view of a photovoltaic module particularly illustrating the laser scribe lines, including scribes filled with a dielectric material;
Fig. 3 is a diagrammatic view of a system and related method for filling voids in a photovoltaic module substrate with a dielectric material; and,
Fig. 4 is a diagrammatic view of an alternative embodiment of a system and method for filling voids in a photovoltaic module substrate with a dielectric material.

Repeat use of reference characters in the present specification and drawings is intended to represent the same or analogous features or elements.

### DETAILED DESCRIPTION OF THE INVENTION

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope of the invention. For instance, features illustrated or described as part of one embodiment can be used with another embodiment to yield a still further embodiment. Thus, it is intended that the present invention covers such modifications and variations as come within the scope of the appended claims and their equivalents.

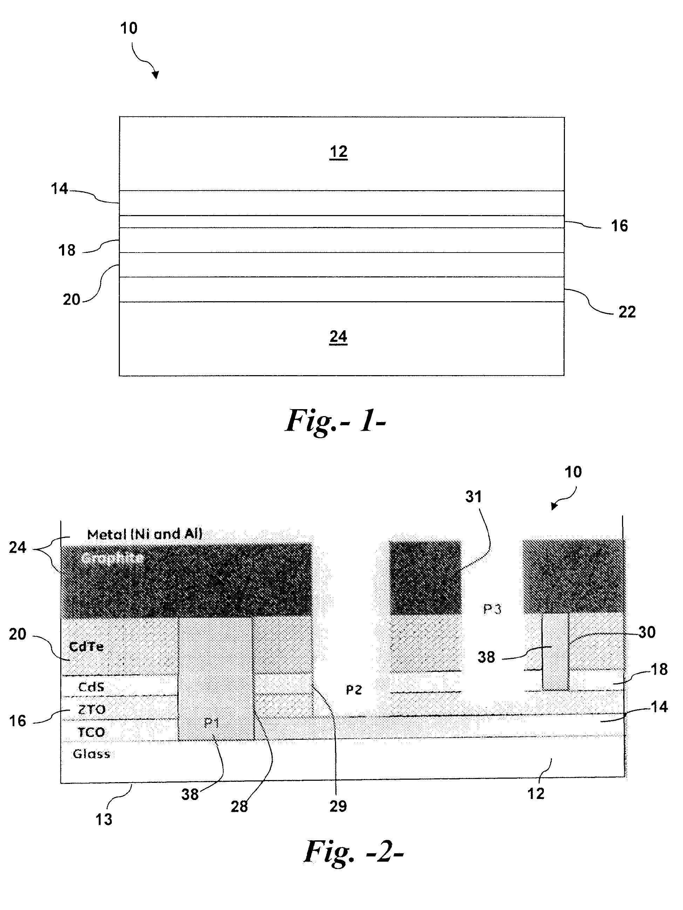

Fig. 1 illustrates a cross-sectional view of a portion of a photovoltaic (PV) module 10. The module 10 includes a substrate 12, such as a glass sheet, having a plurality of thin film layers deposited thereon. It should be appreciated that the present invention is not limited by any particular type of substrate 12 or thin film layers. Typically, a CdTe PV module includes multiple film layers deposited on a glass substrate 12 before deposition of the CdTe layer. For example, the glass substrate 12 may be provided with a transparent conductive oxide (TCO) layer 14 pre-formed thereon, or the TCO layer 14 may be deposited in a subsequent deposition process. The TCO layer 14 allows light to pass through with minimal absorption while also allowing electric current produced by the module 10 to travel sideways to opaque metal conductors (not shown). A resistive transparent buffer (RTB) layer 16 is then applied on the TCO layer 14. The RTB layer 16 may be a zinc-tin oxide (ZTO) layer and may be referred to as a "ZTO layer." A cadmium sulfide (CdS) layer 18 is applied on the RTB layer 16. These various layers may be applied in a conventional sputtering deposition process that involves ejecting material from a target (i.e., the material source), and depositing the ejected material onto the substrate to form the film.

The CdTe layer 20 is deposited on the CdS layer 18 by any known process, such as vapor transport deposition, chemical vapor deposition (CVD), spray pyrolysis, electrodeposition, sputtering, close-space sublimation (CSS), chemical bath deposition, evaporation, etc. The CdTe layer 20 is a p-type layer that generally includes cadmium telluride (CdTe), but may also include other materials. As the p-type layer of the module 10, the CdTe layer 20 is the photovoltaic layer that interacts with the CdS layer 18 (i.e., the n-type layer) to produce current from the absorption of radiation energy by absorbing the majority of the radiation energy passing into the module 10 due to its high absorption coefficient and creating electron-hole pairs. The CdTe layer 20 can have a bandgap tailored to absorb radiation energy (e.g., from about 1.4 eV to about 1.5 eV, such as about 1.45 eV) to create the maximum number of electron-hole pairs with the highest electrical potential (voltage) upon absorption of the radiation energy. Electrons may travel from the p-type side (i.e., the CdTe layer 20) across the junction to the n-type side (i.e., the CdS layer 18) and, conversely, holes may pass from the n-type side to the p-type side. Thus, the p-n junction formed between the CdTe layer 18 and the CdTe layer 20 forms a diode in which the charge imbalance leads to the creation of an electric field spanning the p-n junction. Conventional current is allowed to flow in only one direction and separates the light induced electron-hole pairs.

A series of post-forming treatments can be applied to the exposed surface of the CdTe layer 20. These treatments can tailor the functionality of the CdTe layer 20 and prepare its surface for subsequent adhesion to the back contact layer(s) 22. For example, the CdTe layer 20 can be annealed at elevated temperatures for a sufficient time to create a quality p-type layer. Additionally, copper can be added to the CdTe layer 20 in order to obtain a low-resistance electrical contact between the CdTe layer 20 and a back contact layer(s) 22.

The back contact layer 22 generally serves as the back electrical contact, in relation to the opposite, TCO layer 14 serving as the front electrical contact. The back contact layer 22 can be formed on, and in one embodiment is in direct contact with, the CdTe layer 20. The back contact layer 22 is suitably made from one or more highly conductive materials, such as elemental nickel, chromium, copper, tin, aluminum, gold, silver, technetium or alloys or mixtures thereof. In one particular embodiment, the back contact layer 22 can include graphite, such as a layer of carbon deposited on the CdTe layer followed by one or more layers of metal, such as the metals described above.

In the embodiment of Fig. 1, a laminate 24 (e.g. an encapsulating glass) is shown on the back contact layer 22.

Other components (not shown) can be included in the exemplary module 10 for defining the module into a plurality of individual cells that are connected in series. The charge from the cells is collected via bus bars (e.g., a bus tape) aligned with the extreme opposite cells. A bus bar connector (e.g., a foil ribbon) connects the bus bars to a junction box that includes leads for connecting the module 10 to a load, other modules 10, a grid, and so forth.

Referring to Fig. 2, the various layers of the module 10 discussed above are illustrated after the individual cells and interconnects have been defined by various laser scribe lines 28, 29, 30 (also labeled as P1 through P3 in Fig. 2). As discussed above, it is necessary to fill the cell isolation scribe P1 and, desirably, any other defects or pin-holes in the semiconductor material layers with a dielectric material 38 before the top contact layer or layers 24 are deposited.

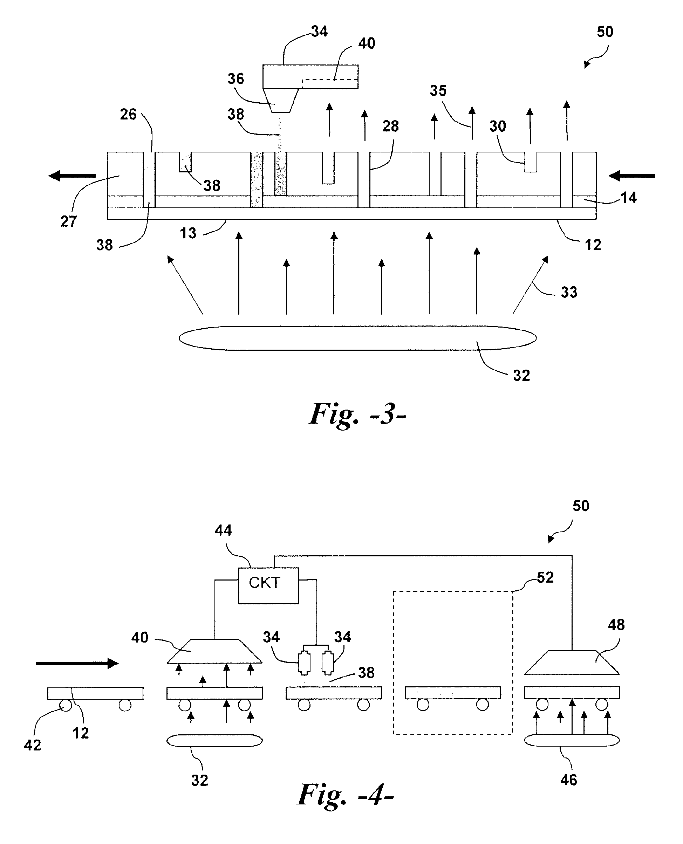

Figs. 3 and 4 illustrate unique embodiments of a system and methodology for filling the voids 26 in the semi-conductor material layers 27 with a printable dielectric material 38. Referring to Fig. 3, and as described above, the voids 26 may be laser scribe lines 28 or pin holes or other defects 30 in the semi-conductor material layers 27. The dielectric material 38 may be any flowable dielectric material that can be applied by a printer. For example, the dielectric material 38 may be an insulating ink, resin, epoxy, adhesive, or any other type of material exhibiting the desired dielectric properties that can be applied by a printer.

The system 50 illustrated in Fig. 3 utilizes a light source 32 disposed at a first side 13 of the substrate 12. The light source 32 transmits light (indicated by the arrows 33) towards the first side 13 of the substrate 12. Voids 26 in the layers 27 on the opposite side of the substrate 12 allow at least a portion of the light to be transmitted completely through the substrate and attached layers, as indicated by the arrows 35 in Fig. 3. Thus, it should be appreciated, that any light that is transmitted completely through the substrate 12 and layers 27 provides an accurate indication of the location of the voids 26 in the layers 27.

The light transmitted through the substrate 12 is detected on the opposite side by any manner of suitable light detector 40 and associated circuitry. The detected light is used as a control parameter for a printer 34. In response to the detected light, the printer 34 registers a print head 36 relative to the voids 26 and dispenses the dielectric material 38 in a sufficient quantity and surface area pattern to fill the voids 26 with the dielectric material 38.

In a particular embodiment, the print head(s) 36 may be set to dispense a fixed thickness of the material 38 in an amount that ensures that the scribe lines 28 and any voids or holes 26 are completely filled. For example, for a 2 micron thick film layer, the heads 36 may be set to dispense a thickness of 2.5 or 3.0 microns of the material 38. Any extra material 38 that flows out of the voids 26 and "spreads" would only incrementally increase the series resistance a minimal amount and would not be detrimental to the module 10. In an alternate embodiment, an active system would variably control the dispensing resolution of the print heads 36 as a function of void size. In this manner, a 100 micron wide scribe line as well as a 50 micron wide pinhole could be filled in a single pass of the print head 50. This type of active system would detect the width of the scribe lines and voids as a function of the amount of light 35 (Fig. 3) that passes through the substrate 12 to the detector 40.

In the embodiment illustrated in Fig. 3, the printer 34 includes an integral light detector 40 and the substrate 12 is moved in a linear direction to the left, as indicated by the arrows. The printer 34 with integrated light detector 40 traverses back and forth across the width of the substrate 12 perpendicular to the linear conveyance direction of the substrate 12. As the detector 40 detects transmitted light from the voids 26, the print head 36 dispenses the dielectric material 38 in a timed sequence so as to fill the voids 26.

It should be appreciated that the invention is not limited to any particular type of printing system or printer 34. In a particular embodiment, the printer 34 may be an ink jet printer that is configured to print an insulating ink or other type of insulating flowable medium having the desired dielectric properties. It should be understood, however, that other conventional printing techniques are within the scope of the invention.

In an alternate embodiment not particularly illustrated in the figures, the printer 34 may be configured so as to move across the length and width of the substrate 12 to detect the transmitted light and fill the respective voids 26. In this particular embodiment, the substrate 12 may be held stationary during the printing process while the printer 34 moves in a complete surface area coverage pattern over the substrate 12.

Fig. 4 illustrates an alternate system 50 and associated method wherein the substrates 12 are conveyed by any manner of conventional conveyor 42 in a linear direction indicated by the arrow in Fig. 4. The substrates 12 are conveyed between a light source 32 and a light detector 40, which operate as described above. The light detector 40 is in communication with a controller or control circuitry 44 that generates a print file or image that is subsequently conveyed to one or multiple printers 34 at a downstream print location. The downstream printers 34 simply print the dielectric material 38 in a pattern or image as dictated by the print file. The print file may be in any suitable data format that is compatible with the printers 34 and control circuitry 44.

From the printing location, the substrates 12 may then be conveyed into a curing or drying chamber 52 that maintains the substrates 12 in any necessary environment for curing or hardening the dielectric material.

Additional system and method embodiments may include a subsequent test station downstream (or upstream) of the curing chamber 52, as illustrated in Fig. 4. Referring to Fig. 4, the substrates 12 may be conveyed to a test station wherein a second light source 46 is configured to transmit light towards a first side of the substrates 12. A second light detector 48 is disposed on the opposite side of the substrates to detect any light that is transmitted through the substrate. Detection of transmitted light may be an indication that the voids 26 were not completely filled by the dielectric material 38. A signal from the second detector 48 may be used as criteria for acceptance or rejection of the substrates 12. Additionally, the signal from the second detector 48 may also be supplied to the control circuitry 44 as a corrective feedback signal to adjust the printers 34 as necessary to correct for any alignment or registration issues that resulted in the unsatisfactory condition.

It should be further appreciated that the invention is not limited to any particular type of light transmission/reception system. For example, the light source 32 may transmit light at any desired frequency range for detection by the light detector 40 on the opposite side of the substrate 12.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

## Claims

1. A method for depositing a dielectric material (38) into voids (26) in one or more of the semiconductor material layers (27) of a photovoltaic (PV) module (10) substrate (12), the voids (26) including any combination of scribe lines (28) and pinhole defects (30), the method comprising:
exposing a first side (13) of the substrate to a light source (32) such that light shines through the substrate and voids in the semiconductor material layers on the opposite side of the substrate;
detecting the light (35) transmitted through the voids; and
controlling a printer (34) in dependence upon the detected light and filling the voids with a printable dielectric material (38) dispensed by the printer.

2. The method as in claim 1, wherein the substrate (12) is conveyed in a linear direction past the printer (34) and the printer is moved in a back-and-forth direction relative to the linear direction to fill the voids (26) across the width of the substrate.

3. The method as in claim 1, wherein the substrate (12) is held stationary as the printer (34) traverses the length and width of the substrate to fill the voids (26).

4. The method as in any preceding claim, wherein the light transmitted through the voids (26) is detected by a light detector (40) and a corresponding print image or file is transmitted to a downstream printer (34) that prints the image or file with the dielectric material (38) to fill the voids.

5. The method as in any preceding claim, further comprising conducting a subsequent light transmission test through the substrate (12) to determine if the voids (26) were satisfactorily filled.

6. The method as in claim 5, further comprising using the results from the subsequent transmission test as a feedback corrective signal to the printer (34).

7. The method as in any preceding claim, wherein the printer (34) is controlled to dispense a fixed thickness of the dielectric material (38) regardless of the size of the scribe lines (28) or pinholes (30).

8. The method as in any one of claims 1 to 6, wherein the printer 34) is controlled to dispense a variable amount of the dielectric material (38) as a function of the size of the scribe lines (28) or pinholes (30).

9. A system (50) for depositing a dielectric material (38) into voids (26) in one or more semiconductor material layers (27) of a photovoltaic (PV) module (10) substrate (12), the voids (26) including any combination of scribe lines (28, 29, 31) and pinhole defects (30), said system comprising:
a light source (32) disposed so as to transmit light to a first side of the substrate (12) such that the light shines through the substrate and voids (26) in the semiconductor material layers (27) on the opposite side of the substrate;
a light detector (40) disposed so as to detect light transmitted through the voids; and
a printer (34) in communication with said light detector, said printer configured to print a dielectric material (38) onto areas of the substrate corresponding to the detected light to fill the voids with the printable dielectric material.

10. The system (50) as in claim 9, wherein said printer (34) is an inkjet printer.

11. The system (50) as in claim 9 or claim 10, further comprising a conveyor (42) that moves the substrates (12) in a linear direction past said printer (34), said printer movable in a back-and-forth direction relative to the linear direction to fill the voids (26) across the width of the substrate.

12. The system (50) as in any one of claims 9 to 11, wherein said printer (34) is configured to traverse the length and width of the substrate (12) to fill the voids (26).

13. The system (50) as in any one of claims 9 to 12, wherein said light detector (40) is an integral component with said printer (34).

14. The system (50) as in any one of claims 9 to 13, further comprising a controller (44) in communication with said light detector (40), said controller configured to generate a print image or file that is transmitted to said printer (34).

15. The system (50) as in claim 14, wherein said controller (44) is configured to vary the amount of dielectric material (38) dispensed by said printer (34) as a function of the size of the voids (26).

16. The system (50) as in claim 9, further comprising a downstream light transmission tester configured to conduct a subsequent light transmission test through the substrate (12) to determine if the voids (26) were satisfactorily filled by said system, said light transmission tester configured in a feedback loop with said printer (34) to provide a corrective feedback signal to said printer.
